# FASCICULE DE BREVET EUROPEEN

(11) **EP 3 644 468 B1**
(45) Date de publication et mention de la délivrance du brevet: **17.01.2024**
(21) Numéro de dépôt: 19203368.6
(22) Date de dépôt: 15.10.2019
(51) Int. Cl.: H02G 15/08, H02G 1/00, G01R 31/12, G01R 29/22, G01R 29/24

(54) **JONCTION DE CÂBLE AVEC DÉTECTEUR DE CHARGE D'ESPACE INTÉGRÉ**
KABELVERBINDUNGSVORRICHTUNG MIT INTEGRIERTEM RAUMLADUNGSDETEKTOR
CABLE JOINT WITH INTEGRATED SPACE CHARGING DETECTOR

(30) Priorité: 25.10.2018 FR 1859859
(43) Date de publication de la demande: 29.04.2020
(73) Titulaire: Nexans, 92400 Courbevoie (FR)
(72) Inventeur: MIREBEAU, Pierre, 91140 VILLEBON SUR YVETTE (FR); GUFFOND, Raphaël, 69007 LYON (FR)
(74) Mandataire: Ipsilon

(56) Documents cités:
- FR-A1- 3 011 637
- US-A1- 2018 062 370

## Description

La présente invention se rapporte à une jonction de câble avec détecteur de charge d'espace intégré.

L'invention appartient au domaine des câbles de puissance, utilisés par exemple dans les systèmes de distribution ou de transmission de puissance électrique. Ce sont généralement des câbles à haute tension et courant continu ou HVDC (en anglais « High Voltage Direct Current »).

Plus précisément, l'invention se rapporte à une jonction de câble embarquant un dispositif permettant la détection de la charge d'espace dans le matériau isolant électriquement compris dans le câble.

Les câbles de puissance du type de ceux utilisés pour la distribution ou la transmission de puissance électrique comportent généralement une partie centrale ou âme en matériau conducteur, une ou plusieurs couches de matériau isolant et une gaine de protection. D'autres couches peuvent être prévues, telles que des couches de blindage.

Les câbles de puissance destinés à des applications à haute tension peuvent comporter des couches internes additionnelles d'isolation électrique ayant pour fonction de maîtriser le champ électrique autour des conducteurs contenus dans le câble. Il est connu du document US-2018-062370 un câble de puissance avec une jonction comprenant des éléments permettant la mesure de phénomènes d'électroluminescence liés à des accumulations de charges.

Certains matériaux isolants électriquement, tels que les matériaux diélectriques, peuvent présenter des gradients de conductivité et des pièges à porteurs de charge qui donnent lieu à une charge d'espace et une répartition non uniforme du champ électrique.

Or si le champ électrique devient localement trop élevé, cela peut provoquer une rupture de l'isolation électrique.

La mesure de la localisation spatiale de ces charges permet de déterminer les mécanismes d'accumulation de charge et d'éviter une telle rupture d'isolation. C'est également un indicateur de l'état de santé du câble.

Il existe des techniques acoustiques de mesure de la localisation spatiale de ces charges d'espace, dans lesquelles une impulsion acoustique est excitée et se propage dans l'échantillon étudié.

Une de ces techniques acoustiques est connue sous le nom de technique PEA ou à impulsions électro-acoustiques (en anglais « Pulsed Electro-Acoustic »). Elle comporte l'application à l'échantillon d'une impulsion de champ électrique extérieur, qui résulte en une impulsion mécanique en provenance des charges contenues dans un matériau diélectrique. Le champ électrique extérieur induit en effet une force de perturbation sur les charges, entraînant une oscillation légère et rapide de ces charges, moyennant quoi des vibrations acoustiques sont créées dans le matériau diélectrique. Ces ondes de pression acoustiques sont proportionnelles à la densité locale des charges dans l'échantillon. Cette technique est mise en oeuvre dans une cellule de mesure PEA telle qu'enseignée dans le document FR-3011637.

Ces ondes de pression acoustiques peuvent être détectées par un transducteur du type piézoélectrique, un transducteur de pression ou capteur de pression, sur un côté du diélectrique.

Grâce à la mesure ou la détection des ondes de pression acoustiques, le signal de sortie du transducteur ou capteur peut être utilisé pour en déduire des informations sur l'amplitude et la localisation des charges dans le diélectrique.

Comme décrit dans le document SE-A-1400395, les mesures PEA sont habituellement effectuées dans une cellule ou un compartiment de mesure où l'échantillon étudié est placé, ainsi qu'éventuellement le capteur de pression.

Cela nécessite, non seulement de déplacer l'échantillon étudié dans un endroit dédié à ces mesures, mais également d'avoir accès au matériau isolant électriquement qui fait l'objet de la mesure de charge d'espace et de disposer des moyens nécessaires à la génération et l'application d'impulsions à haute tension ainsi que des moyens nécessaires à l'enregistrement du signal du transducteur ou capteur de pression pour son traitement, sans compromettre le fonctionnement de l'échantillon sous des contraintes habituelles de courant continu.

La présente invention a pour but de répondre à ces besoins.

Dans ce but, la présente invention propose une jonction de câble de puissance comportant une partie d'extrémité d'un câble de puissance, le câble comportant un matériau isolant électriquement, remarquable en ce qu'elle comporte une région prédéterminée contenant un module de mesure de la charge d'espace du matériau isolant.

Ainsi, le module de mesure de la charge d'espace est intégré dans la jonction. La jonction est donc équipée d'un indicateur de la « santé » de l'isolant électrique du câble. Cela permet de diagnostiquer simplement, facilement et rapidement l'évolution de la qualité de l'isolation électrique dans les liaisons de câbles de puissance.

Le module de mesure comporte au moins deux électrodes.

Selon une caractéristique particulière possible, le module de mesure peut par exemple comporter six électrodes.

Le module de mesure comporte un capteur piézo-électrique.

Cela permet de mesurer la charge d'espace du matériau isolant en utilisant la technique PEA mentionnée plus haut.

Le module de mesure comporte en outre au moins un élément amortisseur de vibrations mécaniques.

Cela permet d'éliminer les vibrations parasites qui perturbent le signal de la charge d'espace.

Dans un mode particulier de réalisation, le module de mesure comporte une ligne acoustique à retard.

Cela permet de séparer temporellement le signal PEA des vibrations parasites causées par l'impulsion électrique, lorsqu'on utilise la technique PEA mentionnée plus haut.

Le module de mesure comporte un module de connexion d'une source d'impulsions électriques à haute tension.

Cela permet de connecter aisément une source d'impulsions électriques à haute tension à la jonction, afin de mettre en oeuvre la technique PEA.

Dans le même but que celui indiqué plus haut, la présente invention propose également un câble de puissance, remarquable en ce qu'il est équipé d'au moins une jonction telle que succinctement décrite ci-dessus.

Selon une caractéristique particulière possible, le câble de puissance est du type à haute tension et courant continu ou HVDC.

Selon une caractéristique particulière possible, le câble peut être extrudé.

Les avantages et les caractéristiques particulières du câble de puissance étant similaires à ceux de la jonction, ils ne sont pas répétés ici.

D'autres aspects et avantages de l'invention apparaîtront à la lecture de la description détaillée ci-après de modes particuliers de réalisation, donnés à titre d'exemples nullement limitatifs, en référence aux dessins annexés, dans lesquels :
- la figure 1 est une vue schématique d'une jonction de câble de puissance conforme à la présente invention, dans un mode particulier de réalisation, la vue étant limitée à la partie de la jonction utile pour représenter l'invention ; et
- la figure 2 est un circuit électrique correspondant à la mesure de la charge d'espace conformément à la présente invention, dans un mode particulier de réalisation.

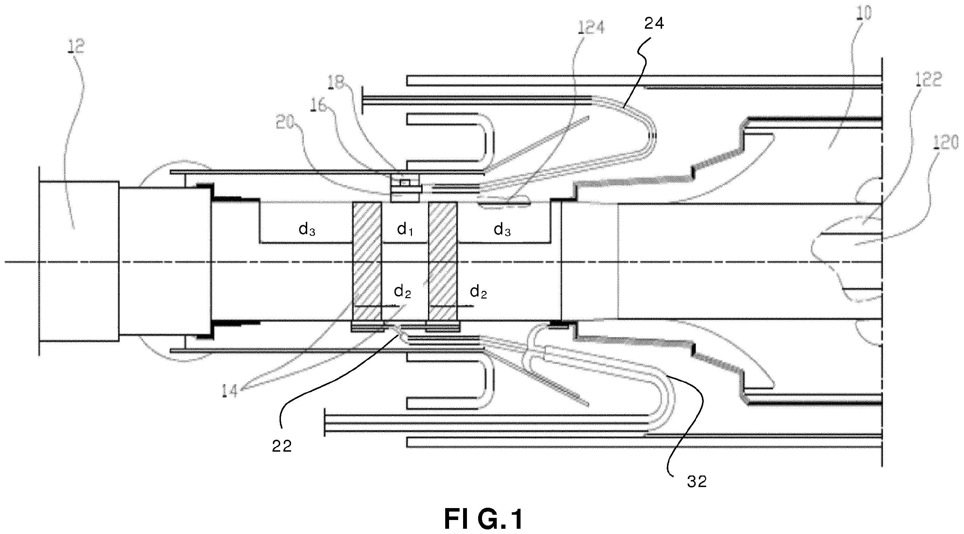

Comme le montre le mode particulier de réalisation de la figure 1, une jonction 10 de câble de puissance conforme à l'invention relie deux câbles de puissance, dont un seul, le câble 12, est représenté, pour simplifier le dessin. La jonction 10 comporte une partie d'extrémité du câble 12.

Le câble 12 de puissance est par exemple du type à haute tension et courant continu ou HVDC.

De façon connue en soi, le câble 12 comporte un conducteur central 120, recouvert d'une couche de matériau électriquement isolant 122, elle-même recouverte d'une couche de matériau semi-conducteur 124. Le câble 12 peut comporter en outre une couche de semi-conducteur interne (non représentée).

Le matériau isolant de la couche 122 est par exemple du polyéthylène réticulé chimiquement ou PRC. Il peut aussi être un matériau d'isolation thermoplastique à base de polyéthylène ou de polypropylène. Tous ces matériaux, qui sont donnés à titre d'exemples nullement limitatifs, peuvent être purs ou chargés.

Conformément à la présente invention, la jonction 10 comporte une région prédéterminée contenant un module de mesure de la charge d'espace du matériau isolant de la couche 122.

Cette région prédéterminée de la jonction 10 est par exemple une de ses deux extrémités.

Le module de mesure de la charge d'espace comporte au moins deux électrodes 14. Il peut par exemple en comporter six. Il comporte également un point de connexion à l'écran du câble 12.

Dans le mode particulier de réalisation illustré sur la figure 1, le module de mesure de la charge d'espace comporte deux électrodes 14, la distance d₁ entre les deux électrodes 14 est de l'ordre de 50 mm, la largeur d₂ de chaque électrode suivant l'axe longitudinal du câble 12 est de l'ordre de 30 mm et la distance d₃ entre chaque électrode 14 et la reconstitution de l'écran métallique, respectivement côté câble et côté jonction, est de l'ordre de 100 mm.

Le module de mesure de la charge d'espace comporte en outre un capteur piézoélectrique 16.

Le capteur piézoélectrique 16 peut par exemple être du type à base de polyfluorure de vinylidène ou PVDF. En variante, il pourrait aussi être du type à base de titanate de baryum (BaTiO₃).

Les électrodes 14 et la connexion à un conducteur central 22 d'une liaison 32 formée par exemple par un câble coaxial servent à créer une zone équipotentielle à haute tension au droit du capteur piézoélectrique 16.

Les électrodes 14 sont avantageusement réalisées en tricot de fils de cuivre étamé. En variante, elles peuvent être réalisées sous forme de rubans de cuivre éventuellement étamé ou en tout autre matériau métallique.

Les électrodes 14 sont par exemple enroulées autour du câble 12, sur sa couche de semi-conducteur 124.

Le capteur piézoélectrique 16 est séparé de l'extérieur du point de vue électrostatique, c'est-à-dire qu'il est dans une cage de Faraday, au sein de l'enveloppe de protection mécanique de la jonction 10.

Afin de supprimer les vibrations mécaniques parasites qui perturbent le signal de mesure de la charge d'espace, le module de mesure comporte au moins un élément 18 amortisseur de vibrations mécaniques placé au contact du capteur piézoélectrique 16.

L'élément 18 amortisseur est par exemple en EPDM (éthylène propylène diène monomère) ou en caoutchouc ou toute autre matière absorbant les vibrations mécaniques.

Pour mesurer la charge d'espace dans le matériau électriquement isolant 122 du câble 12, le module de mesure utilise la technique PEA mentionnée en introduction.

A cet effet, le module de mesure comporte une liaison formée par exemple par un câble coaxial 32 dont le conducteur central 22 est relié aux électrodes 14 et le conducteur coaxial à l'écran métallique du câble 12 et de la jonction 10. Ce câble coaxial 32 et son conducteur central 22 sont des moyens de connexion d'une source d'impulsions électriques à haute tension. La source d'impulsions électriques est extérieure à la jonction.

Afin de séparer temporellement le signal PEA des vibrations parasites causées par l'impulsion électrique, le module de mesure comporte par ailleurs une ligne acoustique à retard 20, connectée au capteur piézoélectrique 16.

Le champ électrique appliqué au matériau électriquement isolant du câble 12 par la source d'impulsions électriques à haute tension est généralement compris entre 0,2 kV et 2 kV par mm d'épaisseur d'isolation du câble 12 et est de préférence environ égal à 0,5 kV/mm.

Lors de l'application de ce champ électrique, le capteur piézoélectrique 16 détecte les ondes de pression acoustique provenant des charges présentes dans le câble 12. La mesure de ces charges peut être recueillie via une liaison connectée au capteur piézoélectrique 16 et formée par exemple par un câble coaxial 24.

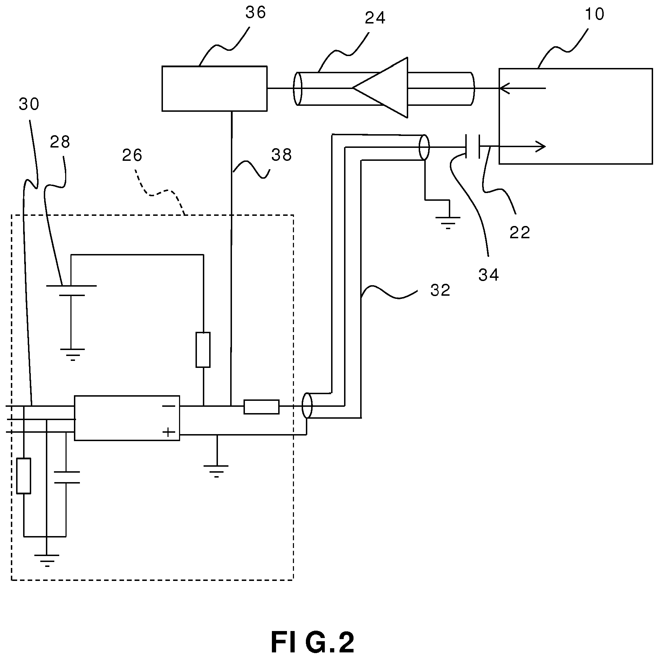

Le schéma de la figure 2 représente un mode particulier de réalisation d'un circuit électrique formé par le module de mesure de la charge d'espace conforme à l'invention et la source 26 extérieure d'impulsions électriques à haute tension.

La source 26 extérieure d'impulsions électriques à haute tension est alimentée par un générateur 28 à haute tension (typiquement 10 kV) et engendre des impulsions à haute tension à partir d'une forme d'onde 30. Ces impulsions sont fournies en entrée à la jonction 10 par l'intermédiaire de la liaison 32 formée par exemple par un câble coaxial et via un condensateur 34 de découplage.

Afin de collecter la mesure de la charge d'espace, le signal provenant du capteur piézoélectrique 16 est acheminé via le câble coaxial 24 jusqu'à un dispositif d'affichage 36, tel qu'un oscilloscope.

Le dispositif d'affichage 36 peut par ailleurs être équipé d'un moyen de déclenchement des impulsions électriques à haute tension, connecté à la source extérieure 26 d'impulsions électriques à haute tension via une liaison 38.

Ainsi, un câble 12 conforme à l'invention, équipé d'au moins une jonction 10 telle que décrite ci-dessus, présente, grâce au module de mesure de la charge d'espace contenu dans la jonction, un indicateur intégré de l'évolution de la qualité de son isolation électrique. L'application principale visée par l'invention concerne les câbles à haute tension et courant continu ou HVDC, qui sont par exemple des câbles extrudés, mais l'invention ne se limite pas à ce type de câbles.

L'invention a été décrite ici dans son application à la mesure de la charge d'espace au sein du matériau électriquement isolant du câble de puissance que la jonction relie à un autre câble. Toutefois, l'invention s'applique de façon similaire à la mesure de la charge d'espace au sein du matériau électriquement isolant de la jonction elle-même.

## Revendications

1. Jonction (10) de câble de puissance comportant une partie d'extrémité d'un câble (12) de puissance, ledit câble (12) comportant un matériau isolant électriquement (122), la jonction (10) comportant une région prédéterminée contenant un module de mesure de la charge d'espace dudit matériau isolant (122) **caractérisée en ce que** ledit module de mesure comporte au moins deux électrodes (14), un capteur piézoélectrique (16), un élément (18) amortisseur de vibrations mécaniques placé en contact avec le capteur piézoélectrique (16) et des moyens (22, 32) de connexion d'une source d'impulsions électriques à haute tension extérieure à la jonction (10), ces moyens de connexion étant formés par un câble coaxial (32) dont un conducteur central (22) est relié aux au moins deux électrodes (14) et dont un conducteur coaxial est relié à un écran métallique du câble.

2. Jonction (10) selon la revendication 1, **caractérisée en ce que** ledit module de mesure comporte six électrodes (14).

3. Jonction (10) selon l'une quelconque des revendications précédentes, **caractérisée en ce que** ledit module de mesure comporte une ligne acoustique à retard (20).

4. Câble (12) de puissance, **caractérisé en ce qu'**il est équipé d'au moins une jonction (10) selon l'une quelconque des revendications précédentes.

5. Câble (12) selon la revendication 4, **caractérisé en ce qu'**il est du type à haute tension et courant continu ou HVDC.

6. Câble (12) selon la revendication 4 ou 5, **caractérisé en ce qu'**il est extrudé.

## Patentansprüche

1. Leistungskabelverbindungsvorrichtung (10), umfassend einen Endteil eines Leistungskabels (12), wobei das Kabel (12) ein elektrisch isolierendes Material (122) umfasst, wobei die Verbindungsvorrichtung (10) eine vorbestimmte Region umfasst, die ein Modul zur Messung der Raumladung des isolierenden Materials (122) umfasst, **dadurch gekennzeichnet, dass** das Modul zur Messung mindestens zwei Elektroden (14) umfasst, einen piezoelektrischen Sensor (16), ein Element (18) zur Dämpfung von mechanischen Vibrationen, das in Kontakt mit dem piezoelektrischen Sensor (16) platziert ist, und Mittel (22, 32) zur Verbindung einer Quelle von elektrischen Hochspannungsimpulsen außerhalb der Verbindung (10), wobei diese Mittel zur Verbindung durch ein koaxiales Kabel (32) gebildet sind, von dem ein zentraler Leiter (22) mit den mindestens zwei Elektroden (14) verbunden ist, und von dem ein koaxialer Leiter mit einer Metallabschirmung des Kabels verbunden ist.

2. Verbindungsvorrichtung (10) nach Anspruch 1, **dadurch gekennzeichnet, dass** das Modul zur Messung sechs Elektroden (14) umfasst.

3. Verbindungsvorrichtung (10) nach einem der vorhergehenden Ansprüche, **dadurch gekennzeichnet, dass** das Modul zur Messung eine akustische Verzögerungsleitung (20) umfasst.

4. Leistungskabel (12), **dadurch gekennzeichnet, dass** es mit mindestens einer Verbindung (10) nach einem der vorhergehenden Ansprüche ausgestattet ist.

5. Kabel (12) nach Anspruch 4, **dadurch gekennzeichnet, dass** es vom Typ Hochspannung und Gleichstrom oder HVDC ist.

6. Kabel (12) nach Anspruch 4 oder 5, **dadurch gekennzeichnet, dass** es extrudiert ist.

## Claims

1. A power cable junction (10) including an end portion of a power cable (12), said cable (12) including an electrically insulating material (122), the junction (10) comprising a predetermined region containing a module for measuring the space charge of said insulating material (122) **characterized in that** said measurement module includes at least two electrodes (14), a piezoelectric sensor (16), a mechanical vibration damper element (18) placed in contact with the piezoelectric sensor (16) and means (22, 32) of connection of a source of high voltage electrical pulses external to the junction (10), the means of connection consisting of a coaxial cable (32), a central conductor (22) of which is connected to at least two electrodes (14) and a coaxial conductor of which is connected to a metal screen of the cable.

2. The junction (10) according to claim 1, **characterized in that** said measurement module includes six electrodes (14).

3. The junction (10) according to any of the preceding claims, **characterized in that** said measurement module includes an acoustic delay line (20).

4. A power cable (12), **characterized in that** the cable is equipped with at least one junction (10) according to any of the preceding claims.

5. The cable (12) according to claim 4, **characterized in that** same is a high voltage direct current (HVDC) cable.

6. The cable (12) according to claim 4 or 5, **characterized in that** the cable is extruded.
